(19) Europäisches Patentamt
European Patent Office
Office européen des brevets

(11) **EP 4 707 834 A1**

(12) **EUROPEAN PATENT APPLICATION**
published in accordance with Art. 153(4) EPC

(43) Date of publication:
**11.03.2026 Bulletin 2026/11**

(21) Application number: **24868491.2**

(22) Date of filing: **20.08.2024**

(51) International Patent Classification (IPC):
**G01R 31/392** (2019.01)   **G01R 31/385** (2019.01)
**G01R 31/382** (2019.01)   **G01R 19/12** (2006.01)
**G01R 19/10** (2006.01)   **G01R 19/30** (2006.01)
**G01R 19/165** (2006.01)   **B60L 58/16** (2019.01)
**B60R 16/033** (2006.01)   **H01M 10/052** (2010.01)

(52) Cooperative Patent Classification (CPC):
**B60L 58/16; B60R 16/033; G01R 19/10;
G01R 19/12; G01R 19/165; G01R 19/30;
G01R 31/382; G01R 31/385; G01R 31/392;
H01M 10/052;** Y02E 60/10

(86) International application number:
**PCT/KR2024/012333**

(87) International publication number:
**WO 2025/063512 (27.03.2025 Gazette 2025/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **20.09.2023   KR 20230125303**

(71) Applicant: **LG Energy Solution, Ltd.**
**Seoul 07335 (KR)**

(72) Inventor: **RO, Chang Suk**
**Daejeon 34122 (KR)**

(74) Representative: **Goddar, Heinz J.**
**Boehmert & Boehmert
Anwaltspartnerschaft mbB
Pettenkoferstrasse 22
80336 München (DE)**

(54) **BATTERY DIAGNOSTIC DEVICE AND OPERATING METHOD THEREOF**

(57) A battery diagnosis apparatus includes a voltage obtaining unit configured to obtain voltage information of each of a plurality of battery units included in each of a plurality of vehicles and a controller configured to calculate a cumulative voltage variance of each of the plurality of battery units, based on the voltage information, calculate at least one deviation that is deviation of cumulative voltage variances for each of the plurality of vehicles, and manage the plurality of battery units based on a distribution of the at least one deviation of the plurality of vehicles.

EP 4 707 834 A1

1

10

20

BATTERY PACK
1000

• • •

BATTERY PACK
2000

BATTERY DIAGNOSIS APAPRATUS
3000

FIG.1

**Description**

**[TECHNICAL FIELD]**

CROSS-REFERENCE TO RELATED APPLICATION

This application claims priority to and the benefit of Korean Patent Application No. 10-2023-0125303 filed in the Korean Intellectual Property Office on September 20, 2023, the entire content of which is incorporated herein by reference.

TECHNICAL FIELD

Embodiments disclosed herein relate to a battery diagnosis apparatus and an operating method thereof.

**[BACKGROUND ART]**

Recently, research and development of secondary batteries have been actively performed. Herein, the secondary batteries, which are chargeable/-dischargeable batteries, may be interpreted as including all of conventional nickel (Ni)/cadmium (Cd) batteries, Ni/metal hydride (MH) batteries, etc., and recent lithium-ion batteries. Recently, the lithium-ion battery is attracting attention as a next-generation energy storage medium as a usage range thereof is expanded to a power source of electric vehicles.

An electric vehicle is supplied with electricity from outside to charge a battery cell, and then the battery cell is discharged to drive a motor and obtain power. The battery cell undergoes internal deformation and denaturation through various chares/discharges in production and use phases, such that physical and chemical characteristics thereof change. For example, venting due to internal short-circuit, external short-circuit, and lithium precipitation or an under-voltage defect in which a voltage of a battery cell decreases below a certain level may occur. A technique for diagnosing and managing a state of the battery cell due to degradation and deterioration of a battery is required.

**[DISCLOSURE]**

**[TECHNICAL PROBLEM]**

Embodiments disclosed herein aim to provide a battery diagnosis apparatus and an operating method thereof in which an abnormal battery cell may be diagnosed based on a voltage variance of a battery bank.

Embodiments disclosed herein aim to provide a battery diagnosis apparatus and an operating method thereof in which an abnormal type of an abnormal battery cell may be diagnosed based on a cumulative voltage variance of a battery bank.

Technical problems of the embodiments disclosed herein are not limited to the above-described technical problems, and other unmentioned technical problems would be clearly understood by one of ordinary skill in the art from the following description.

**[TECHNICAL SOLUTION]**

A battery diagnosis apparatus according to an embodiment disclosed herein includes a voltage obtaining unit configured to obtain voltage information of each of a plurality of battery units included in each of a plurality of vehicles and a controller configured to calculate a cumulative voltage variance of each of the plurality of battery units, based on the voltage information, calculate at least one deviation that is deviation of cumulative voltage variances for each of the plurality of vehicles, and manage the plurality of battery units based on a distribution of the at least one deviation of the plurality of vehicles.

According to an embodiment, the at least one deviation of each of the plurality of vehicles may include at least one of a first deviation and a second deviation.

According to an embodiment, the controller may be further configured to calculate the first deviation by dividing a difference between a maximum value and a median value of the cumulative voltage variance of each of the plurality of battery units included in each of the plurality of vehicles by a standard deviation of the cumulative voltage variance of each of the plurality of battery units.

According to an embodiment, the controller may be further configured to calculate the second deviation by dividing a difference between a minimum value and a median value of the cumulative voltage variance of each of the plurality of battery units included in each of the plurality of vehicles by a standard deviation of the cumulative voltage variance of each of the plurality of battery units.

According to an embodiment, the controller may be further configured to calculate a first distribution of the plurality of vehicles based on the first deviation and calculate a second distribution of the plurality of vehicles based on the second deviation.

According to an embodiment, the controller may be further configured to diagnose, as an abnormal vehicle including an abnormal battery unit, a vehicle having the deviation being greater than or equal to a threshold value in the distribution of the at least one deviation of the plurality of vehicles.

According to an embodiment, the controller may be further configured to diagnose, as being in a capacity abnormality state, a battery unit having a maximum cumulative voltage variance among a plurality of battery units included in the abnormal vehicle.

According to an embodiment, the controller may be further configured to diagnose, as being in an insulation abnormality state, a battery unit having a minimum cumulative voltage variance among a plurality of battery units included in the abnormal vehicle.

According to an embodiment, the voltage information may include a voltage obtained in a charging section of the plurality of battery units.

A battery diagnosis method according to an embodiment disclosed herein includes obtaining voltage information of each of a plurality of battery units included in each of a plurality of vehicles, calculating a cumulative voltage variance of each of the plurality of battery units, based on the voltage information, calculating at least one deviation that is deviation of cumulative voltage variances for each of the plurality of vehicles, and managing the plurality of battery units based on a distribution of the at least one deviation of the plurality of vehicles.

According to an embodiment, the at least one deviation of each of the plurality of vehicles may include at least one of a first deviation and a second deviation.

According to an embodiment, the calculating of the at least one deviation may include calculating the first deviation by dividing a difference between a maximum value and a median value of the cumulative voltage variance of each of the plurality of battery units included in each of the plurality of vehicles by a standard deviation of the cumulative voltage variance of each of the plurality of battery units.

According to an embodiment, the calculating of the at least one deviation may include calculating the second deviation by dividing a difference between a minimum value and a median value of the cumulative voltage variance of each of the plurality of battery units included in each of the plurality of vehicles by a standard deviation of the cumulative voltage variance of each of the plurality of battery units.

According to an embodiment, the battery diagnosis method may further include calculating a first distribution of the plurality of vehicles based on the first deviation and calculating a second distribution of the plurality of vehicles based on the second deviation.

According to an embodiment, the managing of the plurality of battery units may include diagnosing, as an abnormal vehicle including an abnormal battery unit, a vehicle having the deviation being greater than or equal to a threshold value in the distribution of the at least one deviation of the plurality of vehicles.

According to an embodiment, the battery diagnosis method may further include diagnosing, as being in a capacity abnormality state, a battery unit having a maximum cumulative voltage variance among a plurality of battery units included in the abnormal vehicle.

According to an embodiment, the battery diagnosis method may further include diagnosing, as being in an insulation abnormality state, a battery unit having a minimum cumulative voltage variance among a plurality of battery units included in the abnormal vehicle.

According to an embodiment, the voltage information may include a voltage obtained in a charging section of the plurality of battery units.

**[ADVANTAGEOUS EFFECTS]**

A battery diagnosis apparatus and an operating method thereof according to an embodiment disclosed herein may diagnose an abnormal battery cell based on a voltage variance of a battery bank.

The battery diagnosis apparatus and the operating method thereof according to an embodiment disclosed herein may diagnose an abnormal type of an abnormal battery cell based on a cumulative voltage variance of a battery bank.

In addition, various effects identified directly or indirectly through this document may be provided.

**[DESCRIPTION OF DRAWINGS]**

FIG. 1 shows a battery diagnosis system according to an embodiment disclosed herein.

FIG. 2 shows a battery pack according to an embodiment disclosed herein.

FIG. 3 is a block diagram of a battery diagnosis apparatus according to an embodiment disclosed herein.

FIG. 4 is a graph showing a voltage of battery units according to an embodiment disclosed herein.

FIG. 5 is a view showing a distribution of deviation values, according to an embodiment disclosed herein.

FIG. 6 is a flowchart showing operations of a battery diagnosis apparatus according to an embodiment disclosed herein.

FIG. 7 is a flowchart showing operations of a controller according to an embodiment disclosed herein.

FIG. 8 is a block diagram showing a hardware configuration of a computing system for implementing an operating method of a battery management apparatus, according to an embodiment disclosed herein.

**[MODE FOR INVENTION]**

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element).

According to an embodiment of the disclosure, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. In the case of online distribution, at least a part of a computer program product may be at least temporarily stored in a machine-readable storage medium such as a memory of a server of a manufacturer, a server of an application store, or a relay server, or may be generated temporarily.

According to various embodiments of the disclosure, each of the above-described components (e.g., a module or program) may include a single entity or a plurality of entities, some of which may be separately disposed on other components. According to various embodiments of the disclosure, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments of the disclosure, operations performed by a module, a program, or other components may be executed sequentially, in parallel, repeatedly, or heuristically, or one or more of the operations may be executed in a different order or omitted, or one or more other operations may be added.

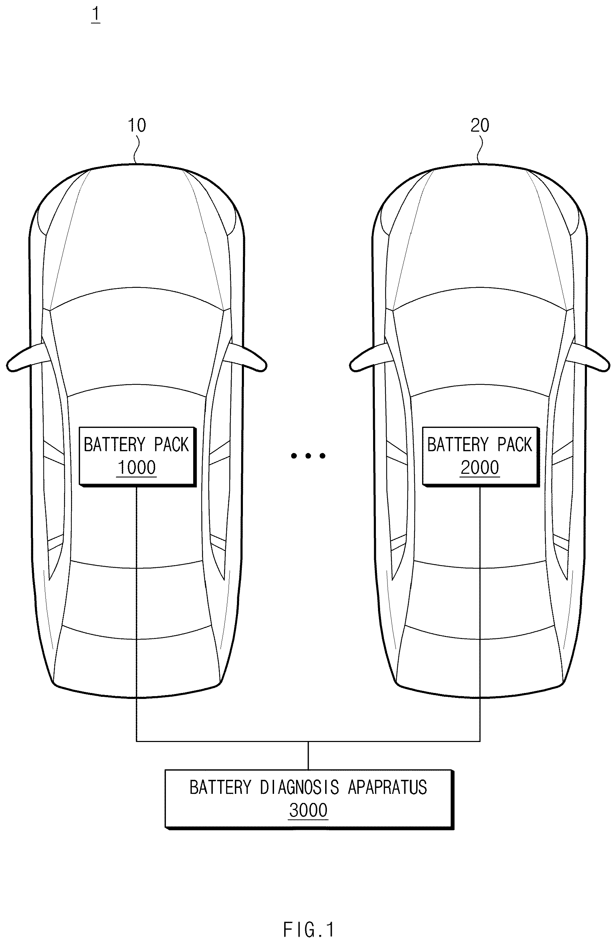

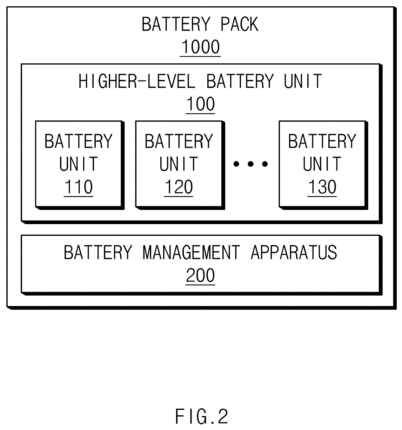

FIG. 1 shows a battery diagnosis system according to an embodiment disclosed herein. FIG. 2 shows a battery pack according to an embodiment disclosed herein.

Referring to FIG. 1, a battery diagnosis system 1 according to various embodiments may include a plurality of vehicles 10 and 20, battery packs 1000 and 2000 respectively included in the plurality of vehicles 10 and 20, and a battery diagnosis apparatus 3000.

According to an embodiment, the plurality of vehicles 10 and 20 may include electrical, electronic, or mechanical vehicles operating with power respectively supplied from the battery packs 1000 and 2000. For example, the plurality of vehicles 10 and 20 may include electric vehicles (EV) and/or two-wheel electric vehicles. Although the number of plural vehicles 10 and 20 is 2 in FIG. 1, the present disclosure is not limited thereto, and the plurality of vehicles 10 and 20 may include n vehicles (n is a natural number equal to or greater than 2).

According to an embodiment, the plurality of vehicles 10 and 20 may include the same type of vehicles. For example, the plurality of vehicles 10 and 20 may be models of the same specification produced by the same EV manufacturer. When the plurality of vehicles 10 and 20 are of the same type, the specifications of components (e.g., the battery pack 1000 and 2000, sensors, motors, acceleration devices, deceleration devices, etc.) respectively included in the plurality of vehicles 10 and 20 are similar and the specifications of the plurality of vehicles 10 and 20 (e.g., charging/discharging mechanisms, fuel efficiencies, etc.) are similar. Thus, the battery diagnosis apparatus 3000 may obtain consistent information from the plurality of vehicles 10 and 20 and improve the accuracy of battery diagnosis based on the obtained information.

The battery packs 1000 and 2000 may be respectively included in the vehicles 10 and 20 and obtain battery-related information in charging/discharging states or driving states of the vehicles 10 and 20. The battery-related information may include voltage information of a battery in a charging or discharging section, voltage information of a battery in the driving states of the vehicles 10 and 20, etc. A detailed description of the battery packs 1000 and 2000 will be provided below with reference to FIG. 2.

Referring to FIG. 2, a battery pack 1000 may include a higher-level battery unit 100 and a battery management apparatus 200. The battery pack 1000 may be included in a vehicle 10. For convenience of a description, the battery pack 1000 included in the vehicle 10 is shown in FIG. 2, but the following description of the battery pack 1000 is identically applicable to the battery pack 2000 included in the vehicle 20.

The higher-level battery unit 100 may include a plurality of battery units 110, 120, ..., 130. For example, when the higher-level battery unit 100 is a battery module, the plurality of battery units 110, 120, ..., 130 may be a plurality of battery cells. For example, the plurality of battery units 110, 120, ..., 130 may be a lithium ion (Li-ion) battery, an Li-ion polymer battery, a nickel-cadmium (Ni-Cd) battery, a nickel hydrogen (Ni-MH) battery, etc., and are not limited thereto.

According to an embodiment, when the higher-level battery unit 100 is a battery module, the plurality of battery units 110, 120, ..., 130 may be a plurality of battery banks. The battery bank may be a set of a plurality of battery cells. For example, the battery bank may be a set of battery cells including three battery cells. According to an embodiment, the battery pack 1000 may include 98 battery banks.

Although the number of the higher-level battery unit 100 is illustrated as 1 in FIG. 1, the disclosure is not limited thereto, and the battery pack 1000 may include n higher-level battery units (n is a natural number equal to or greater than 2). In addition, some components may be excluded from the battery pack 1000 or other general-purpose components may be further included in the battery pack 1000.

The higher-level battery unit 100 may supply power to a target device (e.g., the vehicle 10 or 20). To this end, the higher-level battery unit 100 may be electrically connected to the target device. Herein, the target device may include an electrical, electronic, or mechanical device that operates by receiving power from the battery pack 1000 including the higher-level battery unit 100. For example, the target device may be, but not limited to, an electric vehicle (EV) or an energy storage system (ESS).

The battery management apparatus 200 may manage and/or control a state and/or an operation of the higher-level battery unit 100 and/or the plurality of battery units 110, 120, ..., 130.

Hereinbelow, for convenience of a description of operations of the battery management apparatus 200, each of the higher-level battery unit 100 and/or the plurality of battery units 110, 120, ..., 130 may be referred to as a battery unit 110, but the same content may also be substantially identically applied to the other battery units 120, ..., and 130 or the higher-level battery unit 100.

According to an embodiment, the battery management apparatus 200 may determine a state of the battery unit 110 and manage the state of the battery unit 110 based on the determined state. According to an embodiment, the battery management apparatus 200 may control an operation of the battery unit 110 and manage the operation of the battery unit 110 based on the controlled operation.

According to an embodiment, the battery management apparatus 200 may monitor a voltage, a current, and/or a temperature of the battery unit 110. A sensor or various measurement modules for monitoring, which are not shown, may be additionally installed in any position of the higher-level battery unit 100, a charging/discharging path, the plurality of battery units 110, 120, ..., 130, etc.

According to an embodiment, the battery management apparatus 200 may calculate battery information regarding the state of the battery unit 110 based on a measurement value such as monitored voltage, current, temperature, etc. For example, the battery information regarding the state of the battery unit 110 may include at least one of a state of charge (SOC), a state of health (SOH), a resistance, a current cycle, the remaining prediction cycle, and a C-rate.

According to an embodiment, the battery management apparatus 200 may further include an on-board diagnostic (OBD) device. The OBD device may include not only OBD-I, OBD 1.5, and OBD-II, but also various devices for outputting information related to the state of the battery unit 110 to another device (e.g., the battery diagnosis apparatus 3000). The operation of the battery management apparatus 200 may also be performed in the battery management apparatus 200 or various devices such as a server, a cloud, a charger, a charger/-discharger, etc., connected to a vehicle having a battery management system (BMS) or the battery management apparatus 200 mounted thereon.

According to an embodiment, the battery management apparatus 200 may transmit the monitored voltage, current, and temperature information and the calculated battery information to the battery diagnosis apparatus 3000 (see FIG. 1). Each of the voltage, current, and temperature information and the battery information may include information about the battery unit 110 monitored or calculated. For example, the battery information may include unique identification information of the battery unit 110.

Referring back to FIG. 1, the battery diagnosis apparatus 3000 may receive various information obtained through the battery management apparatus 200 and manage the state of the battery unit 110 based on the received information. For example, the battery diagnosis apparatus 3000 may diagnose abnormal battery units in the battery packs 1000 and 2000 respectively included in the plurality of vehicles 10 and 20.

According to various embodiments, abnormality may occur in a battery cell due to various causes such as a defect in a production stage of the battery cell, internal deformation and degeneration through charging/discharging, an external shock, etc. Abnormality in a battery cell may include lithium precipitation, disconnection, a short-circuit, etc.

According to an embodiment, an abnormal state of a battery cell may include two types including capacity abnormality and insulation abnormality. For example, a capacity abnormality state may occur due to lithium precipitation of the battery cell, and an insulation abnormality state may occur due to an internal short-circuit of the battery cell. According to an embodiment, the insulation abnormality state may include a state in which an electrode in the battery cell is shorted or a phenomenon in which a separator in the battery cell is damaged. Herein, when abnormality occurs in a battery cell, a resistance of the battery cell shows a different pattern compared to a normal battery cell, such that a voltage change of the abnormal battery cell may appear in different ways compared to voltage changes in the normal battery cell.

According to an embodiment, the battery diagnosis apparatus 3000 may diagnose the abnormal battery unit based on voltage information of the plurality of battery units 110, 120, ..., 130 obtained in the charging/discharging section. For example, when a voltage of a battery unit (e.g., 110) in the charging/discharging section changes faster and greater than voltages of the normal battery units (e.g., 120, ..., 130), the battery diagnosis apparatus 3000 may diagnose the battery unit 110 as being in the capacity abnormality state. When a voltage of a battery unit (e.g., 130) in the charging/discharging section changes slower and less than the voltages of the normal battery units (e.g., 120, ..., 130), the battery diagnosis apparatus 3000 may diagnose the battery unit 130 as being in the insulation abnormality state.

The operation of the battery diagnosis apparatus 3000 may also be performed in various devices such as a server, a cloud, a charger, a charger/discharger, etc., connected to the battery management apparatus 200, a BMS, or a vehicle having the battery management apparatus mounted thereon. Details related to abnormality diagnosis of the battery unit 110 performed in the battery diagnosis apparatus 3000 according to an embodiment may be described in detail with reference to the drawings.

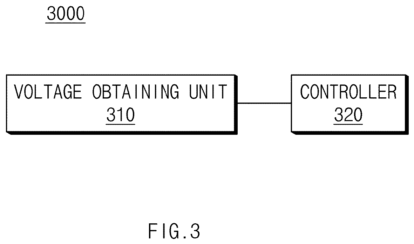

FIG. 3 is a block diagram of a battery diagnosis apparatus according to an embodiment disclosed herein.

Referring to FIG. 3, the battery diagnosis apparatus 3000 may include a voltage obtaining unit 310 and a controller 320. However, without being limited thereto, some components may be omitted from the battery diagnosis apparatus 3000 or other general-purpose components may be further included in the battery diagnosis apparatus 3000.

The voltage obtaining unit 310 may obtain voltage information of a battery included in each of the plurality of vehicles 10 and 20. According to an embodiment, the voltage obtaining unit 310 may obtain voltage information of each of the higher-level battery unit 100 and the plurality of battery units 110, 120, ..., 130 included in each of the plurality of vehicles 10 and 20.

The voltage obtaining unit 310 may obtain, every unit time, the voltage information of each of the plurality of battery units 110, 120, ..., 130 measured in a predetermined time section. According to an embodiment, the voltage obtaining unit 310 may continuously obtain information related to voltage rise and drop in a charging section, a rest section after charging, a discharging section, and/or a rest section after discharging of the plurality of battery units 110, 120, ..., 130.

According to an embodiment, the voltage obtaining unit 310 may obtain voltage information of the plurality of vehicles 10 and 20 in the charging section during a predetermined period. For example, the predetermined period may include a predetermined period such as one week, two weeks, one month, etc. The predetermined period may be determined based on a predetermined number of times of charging/discharging.

For example, the voltage information of the plurality of battery units 110, 120, ..., 130 obtained by the voltage obtaining unit 310 may include charging voltage information in which the number of times of charging is at least 5. When the number of times of charging is small, population voltage information for diagnosis of the plurality of battery units 110, 120, ..., 130 may not be sufficient. Thus, the voltage obtaining unit 310 may obtain voltage information in the charging section during a predetermined period to improve the reliability of diagnosis of an abnormal battery unit.

According to an embodiment, the voltage obtaining unit 310 may include a voltage monitoring circuit or sensor.

The controller 320 may control operations of the battery diagnosis apparatus 3000. The controller 320 may manage a state of each of the higher-level battery unit 100 and the plurality of battery units 110, 120, ..., 130. According to an embodiment, the controller 320 may determine whether each of the plurality of battery units 110, 120, ..., 130 is abnormal and manage the state thereof, based on the voltages of the plurality of battery units 110, 120, ..., 130, obtained by the voltage obtaining unit 310.

According to an embodiment, the controller 320 may diagnose an abnormal battery unit based on voltage information of the plurality of battery units 110, 120, ..., 130 in the charging/discharging section. According to an embodiment, the controller 320 may diagnose the vehicle 10 including the abnormal battery unit (e.g., 110) as an abnormal vehicle.

According to an embodiment, the controller 320 may diagnose a type of an abnormal state of the battery unit 110. For example, the controller 320 may diagnose whether the abnormal battery unit (e.g., 110) is the capacity abnormality state or the insulation abnormality state. The voltage of the battery unit 100 shows a different behavior according to the type of the abnormality state of the battery unit 110. Thus, the controller 320 may analyze a tendency of an abnormal value based on the voltage information of the plurality of battery units 110, 120, ..., 130 included in each of the plurality of vehicles 10 and 20 to diagnose the type of the abnormality state of each of the plurality of battery units 110, 120, ..., 130.

The controller 320 may have a structure for executing instructions that implement the operations of the battery diagnosis apparatus 3000. The controller 320 may be implemented with an array of multiple logic gates or a general-purpose microprocessor for processing various operations, and may include a single processor or a plurality of processors. For example, the controller 320 may be implemented in the form of at least one of a microprocessor, a CPU, a GPU, and an AP.

The processor 320 may be configured separately from or integrally with a memory and/or a storage configured to store instructions, and may process various operations by executing the instructions stored in the memory and/or the storage. The memory and/or the storage may store various data, instructions, mobile application programs, computer programs, etc. For example, the memory and/or storage may be implemented in the form of a non-volatile memory device such as ROM, PROM, EPROM, EEPROM, flash memory, PRAM, MRAM, RRAM, FRAM, etc., or a volatile memory device such as DRAM, SRAM, SDRAM, RRAM, RRAM, FeRAM, a form such as HDD, SSD, SD, Micro-SD, etc., or may be implemented in the form of a combination thereof.

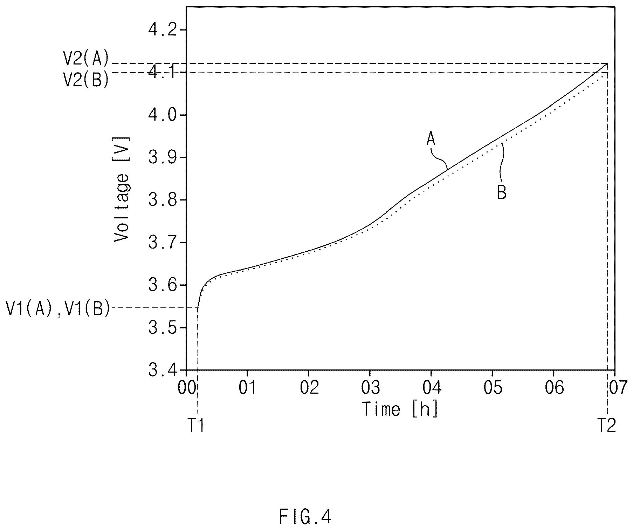

The controller 320 may analyze voltage information of the charging/discharging section and/or the rest section to manage each of the plurality of battery units 110, 120, ..., 130 and diagnose the state of each of the plurality of battery units 110, 120,..., 130. When it is determined that the battery unit (e.g., 110) is abnormal as a result of diagnosis, the controller 320 may provide a user with information about an abnormal battery unit (e.g., 110). For example, the controller 320 may provide information about an abnormal battery unit to a user terminal through a communication circuit (not shown) and provide the information about the abnormal battery unit through a display provided in a vehicle, a charger, etc. A detailed operation of the controller 320 according to an embodiment will be described below with reference to FIG. 4.

FIG. 4 is a graph showing a voltage of battery units according to an embodiment disclosed herein.

Referring to FIG. 4, the controller 320 may obtain time-series information of the voltage of each of the plurality of battery units 110, 120, ..., 130 based on the voltage information of the plurality of battery units 110, 120, ..., 130 obtained from the voltage obtaining unit 310 every unit time. According to an embodiment, the voltage information of the plurality of battery units 110, 120, ..., 130 may be obtained during the predetermined time section. For example, the voltage information may include a voltage obtained in the charging section of each of the plurality of battery units 110, 120, ..., 130.

The controller 320 may calculate a graph (e.g., a voltage graph) indicating a voltage change of each of the plurality of battery units 110, 120, ..., 130 based on the voltage information of each of the plurality of battery units 110, 120, ..., 130 every unit time. According to an embodiment, the voltage graph may be a graph related to the voltage of each of the plurality of battery units 110, 120, ..., 130 with respect to time. For example, an x axis of the voltage graph may be time (unit: time) and a y axis may indicate a voltage (unit: volt).

The controller 320 may calculate, as a voltage graph, each of a voltage profile of a first battery unit A and a voltage profile of a second battery unit B. While two battery units are shown in FIG. 4, the present disclosure is not limited thereto, and the controller 320 may calculate the voltage graph based on the voltage information of each of the plurality of battery units 110, 120, ..., 130 included in each of the battery packs 1000 and 2000 respectively included in the plurality of vehicles 10 and 20.

According to an embodiment, the controller 320 may calculate the voltage graph based on voltage information of each of the plurality of battery units 110, 120, ..., 130 in the charging section. For example, a section between times T1 and T2 may mean a first charging section T1 to T2 in which the first battery unit A and the second battery unit B are charged.

In the charging section, the voltage information of the plurality of battery units 110, 120, ..., 130 may include information about a voltage rise when a specific current is applied. On the other hand, the voltage information in a driving section or the discharging section may include voltage rise and voltage drop regions. Thus, the voltage information in the driving section or the discharging section may not indicate a relationship between current and voltage applied, and may not accurately indicate the state of each of the plurality of battery units 110, 120, ..., 130. In another aspect, the voltage information in the charging section may more accurately represent the states of the plurality of battery units 110, 120, ..., 130 than the voltage information in the driving section, the discharging section, or the rest section. Therefore, the controller 320 may use the voltage of each of the plurality of battery units 110, 120, ..., 130 obtained in the charging section, thereby accurately managing behaviors of the plurality of battery units 110, 120, ..., 130 when compared to data obtained in the driving section, the discharging section, or the rest section.

According to an embodiment, the controller 320 may calculate a voltage variance $V_\Delta$ of each of the plurality of battery units 110, 120, ..., 130 in the charging section. Herein, the voltage variance $V_\Delta$ may mean a degree to which the voltage of each of the plurality of battery units 110, 120, ..., 130 rises in one charging section. In another aspect, the voltage variance $V_\Delta$ of each of the plurality of battery units 110, 120, ..., 130 in the charging section may mean a difference between a charging start voltage V1 in the charging section and a charging end voltage V2 in the charging section. According to an embodiment, the controller 320 may calculate the voltage variance $V_\Delta$ of each of the plurality of battery units 110, 120, ..., 130 in the charging section using Equation 1.

[Equation 1]

$$V_{\Delta 1}(k) = V2(k) - V1(k)$$

In Equation 1, k may indicate a $k^{th}$ battery unit k, $V_{\Delta 1}(k)$ may indicate a voltage variance of the battery unit k in a first charging section, V1(k) may indicate a charging start voltage of the battery unit k of the first charging section, and V2(k) may indicate a charging end voltage of the battery unit k of the first charging section. For example, the voltage variance $V_{\Delta 1}(A)$ of the first battery unit A in the first charging section T1 to T2 may mean a difference $(V_{\Delta 1}(A)=V2(A)-V1(A))$ between the charging start voltage V1(A) and the start end voltage V2(A) of the first charging section.

According to an embodiment, the controller 320 may calculate a cumulative voltage variance $V_{\Delta tot}$ of each of the plurality of battery units 110, 120, ..., 130 based on the voltage variance $V_\Delta$ of each of the plurality of battery units 110, 120, ..., 130. Herein, a cumulative voltage variance $V_{\Delta tot}$ of the $k^{th}$ battery unit k may mean a sum of voltage variances $V_{\Delta1}(k)$, $V_{\Delta2}(k)$, ..., $V_{\Delta3}(k)$ of the battery unit k obtained in a plurality of charging sections. In another aspect, the cumulative voltage variance $V_{\Delta tot}$ of each of the plurality of battery units 110, 120, and 130 may include a cumulative value of the first voltage variance $V_{\Delta1}$, the second voltage variance $V_{\Delta2}$, ..., the third voltage variance $V_{\Delta3}$ respectively obtained in the first charging section, the second charging section, ..., the third charging section. According to an embodiment, the controller 320 may calculate the cumulative voltage variance $V_{\Delta tot}$ based on the voltage information of each of the plurality of battery units 110, 120, ..., 130 obtained in five or more charging sections.

According to an embodiment, the controller 320 may calculate the cumulative voltage variance $V_{\Delta tot}$ of each of the plurality of battery units 110, 120, ..., 130 in the charging section using Equation 2.

[Equation 2]

$$V_{\Delta tot}(k) = V_{\Delta1}(k) + V_{\Delta2}(k) + \ldots + V_{\Delta3}(k)$$

In Equation 2, k may indicate the $k^{th}$ battery unit k, $V_{\Delta tot}(k)$ may indicate a cumulative voltage variance of the battery unit k in a plurality of charging sections, $V_{\Delta1}(k)$ may indicate a voltage variance of the battery unit k in the first charging section, $V_{\Delta2}(k)$ may indicate a voltage variance of the battery unit k in the second charging section, and $V_{\Delta3}(k)$ may indicate a voltage variance of the battery unit k in the third charging section. For example, the cumulative voltage variance $V_{\Delta tot}(A)$ of the first battery unit A in five charging sections may mean a sum of a voltage variance $V_{\Delta1}(A)$ in the first charging section, a voltage variance $V_{\Delta2}(A)$ in the second charging section, a voltage variance $V_{\Delta3}(A)$ in the third charging section, a voltage variance $V_{\Delta4}(A)$ in the fourth charging section, and a voltage variance $V_{\Delta5}(A)$ in the fifth charging section ($V_{\Delta tot}(A) = V_{\Delta1}(A) + V_{\Delta2}(A) + V_{\Delta3}(A) + V_{\Delta4}(A) + V_{\Delta5}(A)$).

According to an embodiment, a difference ($V_{\Delta1}(A) - V_{\Delta1}(B)$) between the voltage variance $V_{\Delta1}(A)$ of the first battery unit A and the voltage variance $V_{\Delta1}(B)$ of the second battery unit B in the first charging section may be very small. On the other hand, a difference ($V_{\Delta tot}(A) - V_{\Delta tot}(B)$) between the cumulative voltage variance $V_{\Delta tot}(A)$ of the first battery unit A and the cumulative voltage variance $V_{\Delta tot}(B)$ of the second battery unit B, calculated in the plurality of charging sections, may be greater than the difference ($V_{\Delta1}(A) - V_{\Delta1}(B)$) in voltage variance. Thus, the controller 320 may more reliability analyze the voltage variance based on the cumulative voltage variance $V_{\Delta tot}(k)$ of each of the plurality of battery units 110, 120, ..., 130 in the plurality of charging sections, and accurately diagnose the abnormal battery unit.

According to an embodiment, a slope of the voltage variance $V_\Delta$ or the cumulative voltage variance $V_{\Delta tot}$ of each of the plurality of battery units 110, 120, ..., 130 with respect to time may include resistance information. Herein, a factor affecting a resistance of a battery cell may include a defect of the battery cell, such as lithium precipitation, disconnection, a short-circuit, etc. For example, an abnormal state of a battery cell may include two types including capacity abnormality and insulation abnormality. The capacity abnormality state may occur due to lithium precipitation of the battery cell, and the insulation abnormality state may occur due to an internal short-circuit of the battery cell. According to an embodiment, the insulation abnormality state may include a state in which an electrode in the battery cell is shorted or a phenomenon in which a separator in the battery cell is damaged. Herein, when abnormality occurs in a battery cell, a resistance of the battery cell shows a different pattern compared to a normal battery cell, such that a voltage change of the abnormal battery cell may appear in different ways compared to voltage changes in the normal battery cell. Thus, the controller 320 may calculate the cumulative voltage variance $V_{\Delta tot}$ of each of the plurality of battery units 110, 120, ..., 130 in a plurality of charging sections, and manage each of the plurality of battery units 110, 120, ..., 130 based on the calculated cumulative voltage variances. Hereinbelow, a description will be made of an operation, performed by the controller 320, of calculating a deviation D of the plurality of battery units 110, 120, ..., 130 based on the cumulative voltage variance $V_{\Delta tot}$ of each of the plurality of battery units 110, 120, ..., 130, and calculating a distribution P of the deviation D.

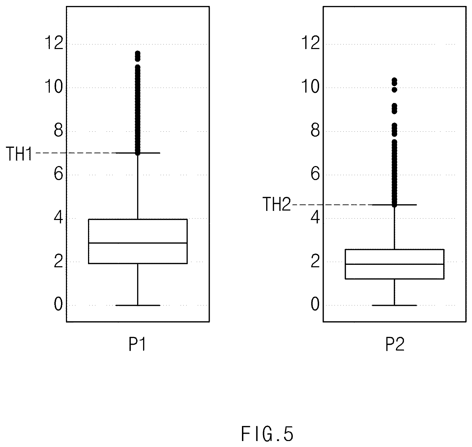

FIG. 5 is a view showing a distribution of deviation values, according to an embodiment disclosed herein.

Referring to FIG. 5, the controller 320 may calculate the deviation D of the cumulative voltage variances $V_{\Delta tot}(A)$, $V_{\Delta tot}(B)$, ..., $V_{\Delta tot}(k)$ for each of the plurality of vehicles 10 and 20. Herein, the deviation D may mean a degree to which the cumulative voltage variances $V_{\Delta tot}(A)$, $V_{\Delta tot}(B)$, ..., $V_{\Delta tot}(k)$ of the plurality of battery units 110, 120, ..., 130 included in the single vehicle 10 deviate from a median value. According to an embodiment, the controller 320 may calculate the deviation D for each single vehicle 10 or 20. In this way, the controller 320 may detect an abnormal value from the plurality of battery units 110, 120, ..., 130 included in the single vehicle 10 or 20.

According to an embodiment, the controller 320 may calculate at least one deviation D for each of the plurality of vehicles 10 and 20. Herein, the at least one deviation D may include a first deviation D1 and a second deviation D2. For example, the controller 320 may calculate the first deviation D1 and the second deviation D2 of the vehicle 10 and calculate the first deviation D1 and the second deviation D2 of the vehicle 20.

Hereinbelow, an operation, performed by the controller 320, of calculating a deviation of cumulative voltage variances for the vehicle 10 will be described, but the present disclosure is not limited thereto, and the same manner may be applied to an operation, performed by the controller 320, of calculating a deviation of the vehicle 20.

According to an embodiment, the controller 320 may calculate the first deviation D1 of the vehicle 10 based on a cumulative voltage variance of a battery unit having the greatest voltage variance among the plurality of battery units 110, 120, ..., 130 included in the vehicle 10. The controller 320 may calculate the second deviation D2 of the vehicle 10 based on a cumulative voltage variance of a battery unit having the least voltage variance among the plurality of battery units 110, 120, ..., 130 included in the vehicle 10. In this way, the controller 320 may diagnose a battery unit having the greatest or least cumulative voltage variance among the plurality of battery units 110, 120, ..., 130 included in the vehicle 10 based on at least one of the first deviation D1 and the second deviation D2.

According to an embodiment, the controller 320 may calculate the first deviation D1 by dividing a difference between a maximum value and a median value of the cumulative voltage variance $V_{\Delta tot}$ of each of the plurality of battery units 110, 120, ..., 130 included in the vehicle 10 by a standard deviation of the cumulative voltage variance $V_{\Delta tot}$ of each of the plurality of battery units 110, 120, ..., 130. According to an embodiment, the controller 320 may calculate the second deviation D2 by dividing a difference between a minimum value and the median value of the cumulative voltage variance $V_{\Delta tot}$ of each of the plurality of battery units 110, 120, ..., 130 included in the vehicle 10 by a standard deviation of the cumulative voltage variance $V_{\Delta tot}$ of each of the plurality of battery units 110, 120, ..., 130. Thus, the controller 320 may detect an abnormal value based on the first deviation D1 and the second deviation D2 and diagnose an abnormal battery unit among the plurality of battery units 110, 120, .., 130.

According to an embodiment, the controller 320 may calculate the first deviation D1 based on Equation 3, and calculate the second deviation D2 based on Equation 4.

[Equation 3]

$$D1 = (V_{\Delta tot}(Max) - V_{\Delta tot}(Med))/(Std(V_{\Delta tot}))$$

[Equation 4]

$$D2 = (V_{\Delta tot}(Med) - V_{\Delta tot}(Min))/(Std(V_{\Delta tot}))$$

In Equation 3 and Equation 4, D1 may indicate the first deviation, D2 may indicate the second deviation, $V_{\Delta tot}(Max)$ may indicate a maximum value of the cumulative voltage variance, $V_{\Delta tot}(Min)$ may indicate a minimum value of the cumulative voltage variance, $V_{\Delta tot}(Med)$ may indicate a median value of the cumulative voltage variance, and $Std(V_{\Delta tot})$ may indicate a standard deviation of the cumulative voltage variance. Herein, as the controller 320 may calculate the first deviation D1 and the second deviation D2 based on the single vehicle (e.g., 10), the controller 320 may calculate all of the maximum value $V_{\Delta tot}(Max)$ of the cumulative voltage variance, the minimum value $V_{\Delta tot}(Min)$ of the cumulative voltage variance, the median value $V_{\Delta tot}(Med)$ of the cumulative voltage variance, and the standard deviation $Std(V_{\Delta Mot})$ of the cumulative voltage variance based on the cumulative voltage variances of the plurality of battery units 110, 120, ..., 130 included in the single vehicle (e.g., 10).

The cumulative voltage variances $V_{\Delta tot}$ of most battery units may not be quite different from the median value $V_{\Delta tot}(Med)$ of all the battery units, and a deviation of voltage variances of some defective battery units may be large. Thus, the controller 320 may diagnose an abnormal battery unit among the plurality of battery units 110, 120, ..., 130 based on the first deviation D1 and the second deviation D2.

According to an embodiment, the controller 320 may manage the plurality of battery units 110, 120, ..., 130 based on the distribution P of the at least one deviation D of the plurality of vehicles 10 and 20. Herein, the distribution P of the deviation D of the plurality of vehicles 10 and 20 may mean a distribution of deviations respectively calculated for the plurality of vehicles 10 and 20. For example, the distribution P of the deviation of the plurality of vehicles 10 and 20 may mean a degree to which the deviation D of the vehicle 10, ..., and the deviation D of the vehicle 20 are dispersed.

According to an embodiment, the controller 320 may calculate the distribution P of the deviation of the plurality of vehicles 10 and 20 based on a random statistical analysis method. Herein, the statistical analysis method may include an analysis method through standard normal distribution, an interquartile range (IQR) analysis method, etc. Herein, the IQR analysis method may mean interquartile range analysis. An interquartile range may mean a middle 50 % range of the entire data, i.e., a range (25 % to 75 %) between a first quartile and a third quartile of data. The controller 320 may calculate a degree to which a deviation of the plurality of vehicles 10 and 20 is dispersed and detect an abnormal value, in various statistical analysis manners.

The deviation of the plurality of vehicles 10 and 20 may not be significantly different from an average of the deviation of all the vehicles, and a deviation of the vehicle 10 including the defective battery unit (e.g., 110) may be large. Therefore, the controller 320 may diagnose the vehicle 10 including the defective battery unit (e.g., 110) by detecting an abnormal value in the distribution P of the deviation. Thus, the controller 320 may diagnose both the vehicle including the abnormal battery unit and the abnormal battery unit based on the distribution P of the deviation of the plurality of vehicles 10 and 20.

According to an embodiment, the distribution P of at least one deviation of the plurality of vehicles 10 and 20 may include a first distribution P1 and a second distribution P2. Herein, the first distribution P1 may be a distribution of the first deviation D1 of each of the plurality of vehicles 10 and 20, and the second distribution P2 may be a distribution of the second deviation D2 of each of the plurality of vehicles 10 and 20. For example, the controller 320 may calculate the first distribution P1 of the plurality of vehicles 10 and 20 based on the first deviation D1 of the plurality of vehicles 10 and 20. The controller 320 may calculate the second distribution P2 of the plurality of vehicles 10 and 20 based on the second deviation D2 of the plurality of vehicles 10 and 20.

According to an embodiment, the controller 320 may diagnose both an abnormal vehicle and an abnormal battery unit based on the distribution P of the deviation of the plurality of vehicles 10 and 20. Herein, the abnormal vehicle may mean a vehicle including the abnormal battery unit. According to an embodiment, the controller 320 may diagnose, as the abnormal vehicle, the vehicle having the deviation being at least a threshold value TH in the distribution P of the at least one deviation of the plurality of vehicles 10 and 20. The threshold value TH may be a reference value for detecting the abnormal value in the distribution P of the deviation.

According to an embodiment, the controller 320 may determine the threshold value TH by using the IQR analysis method. According to an embodiment, the controller 320 may determine an IQR abnormal value (i.e., a value greater than 1.5 times the interquartile range) in the distribution P of the deviation of the plurality of vehicles 10 and 20.

According to an embodiment, the controller 320 may determine a first threshold value TH1 in the first distribution P1 and a second threshold value TH2 in the second distribution P2. For example, the threshold value TH in the first distribution P1 may be different from that in the second distribution P2.

Thus, the controller 320 may diagnose, as the abnormal vehicle including the abnormal battery unit, the vehicle having the deviation being at least a threshold value TH in the distribution P of the at least one deviation of the plurality of vehicles 10 and 20. For example, when the first deviation D1 of the vehicle 10 is greater than or equal to the first threshold value TH1 in the first distribution P1, the controller 320 may diagnose the vehicle 10 as an abnormal vehicle. When the second deviation D2 of the vehicle 10 is greater than or equal to the second threshold value TH2 in the second distribution P2, the controller 320 may diagnose the vehicle 10 as an abnormal vehicle.

According to an embodiment, the controller 320 may diagnose the battery unit (e.g., 110) corresponding to the abnormal value of the first distribution P1 as being in the capacity abnormality state. For example, the controller 320 may diagnose, as in the capacity abnormality state, the battery unit (e.g., 110) having the maximum cumulative voltage variance among the plurality of battery units 110, 120, ..., 130 included in the abnormal vehicle 10. The cumulative voltage variance of the battery unit (e.g., 110) having capacity abnormality may be greater than that of a normal battery unit (e.g., 120, ..., 130). Thus, the controller 320 may diagnose the battery unit 110 having the maximum cumulative voltage variance as being in the capacity abnormality state.

According to an embodiment, the controller 320 may diagnose the battery unit (e.g., 130) corresponding to the abnormal value of the second distribution P2 as being in the insulation abnormality state. For example, the controller 320 may diagnose, as in the insulation abnormality state, the battery unit (e.g., 130) having the minimum cumulative voltage variance among the plurality of battery units 110, 120, ..., 130 included in the abnormal vehicle 10. The cumulative voltage variance of the battery unit (e.g., 130) having insulation abnormality may be less than that of a normal battery unit (e.g., 110, 120, ...). Thus, the controller 320 may diagnose the battery unit 130 having the minimum cumulative voltage variance as being in the insulation abnormality state.

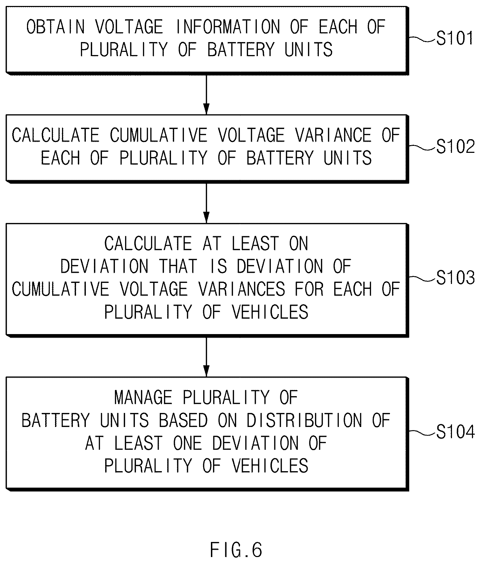

FIG. 6 is a flowchart showing operations of a battery diagnosis apparatus according to an embodiment disclosed herein.

Referring to FIG. 6, the operations of the battery diagnosis apparatus 3000 may include operation S101, performed by the voltage obtaining unit 310, of obtaining voltage information of each of the plurality of battery units 110, 120, ..., 130 included in each of the plurality of vehicles 10 and 20, operation S102, performed by the controller 320, of calculating the cumulative voltage variance $V_{\Delta tot}$ of each of the plurality of battery units 110, 120, ..., 130 based on the voltage information, operation S103 of calculating the tat least one deviation D that is a deviation of the cumulative voltage variances $V_{\Delta tot}$ for each of the plurality of vehicles 10 and 20, and operation S104 of managing the plurality of battery units 110, 120, ..., 130 based on the distribution P of the at least one deviation D of the plurality of vehicles 10 and 20.

In operation S101, the voltage obtaining unit 310 may obtain voltage information of each of the plurality of battery units 110, 120, ..., 130 included in each of the plurality of vehicles 10 and 20.

In operation S102, the controller 320 may calculate the cumulative voltage variance $V_{\Delta tot}$ of each of the plurality of battery units 110, 120, ..., 130, based on the voltage information. According to an embodiment, the controller 320 may calculate the voltage variance $V_{\Delta}$ of each of the plurality of battery units 110, 120, ..., 130 based on the voltage information and calculate the cumulative voltage variance $V_{\Delta tot}$ based on the voltage variance $V_{\Delta}$.

In operation S103, the controller 320 may calculate the at least one deviation D that is a deviation of the cumulative voltage variances $V_{\Delta tot}$ for each of the plurality of vehicles 10 and 20.

In operation S104, the controller 320 may manage the plurality of battery units 110, 120, ..., 130 based on the distribution P of the at least one deviation D of the plurality of vehicles 10 and 20.

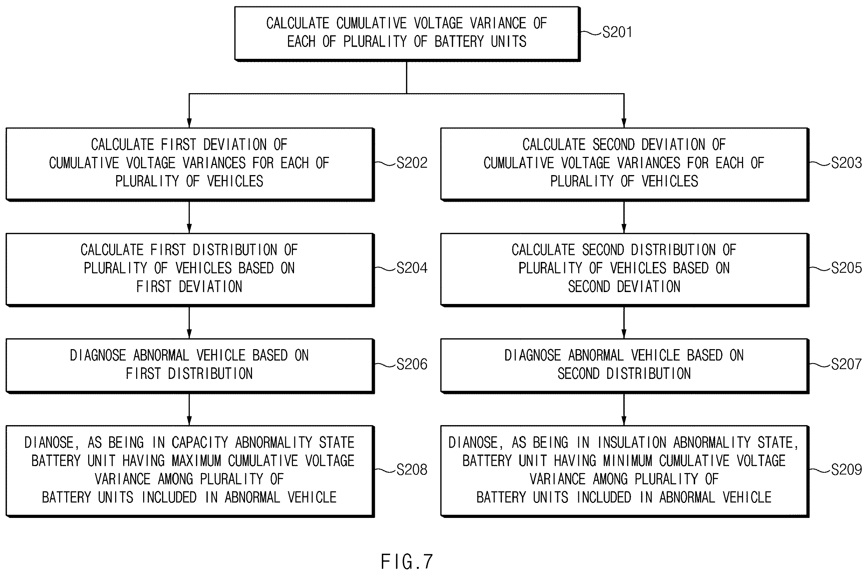

FIG. 7 is a flowchart showing operations of a controller according to an embodiment disclosed herein.

Referring to FIG. 7, the operations of the controller 320 may include operation S201 of calculating the cumulative voltage variance $V_{\Delta tot}$ of each of the plurality of battery units 110, 120, ..., 130, operation S202 of calculating the first deviation D1 that is a deviation of the cumulative voltage variances $V_{\Delta tot}$ for each of the plurality of vehicles 10 and 20, operation S204 of calculating the first distribution P1 of the plurality of vehicles 10 and 20 based on the first deviation D1, operation S206 of diagnosing the abnormal vehicle 10 based on the first distribution P1, and operation S208 of diagnosing, as being in the capacity abnormality state, the battery unit 110 having the maximum cumulative voltage variance among the plurality of battery units 110, 120, ..., 130 included in the abnormal vehicle 10.

Also, referring to FIG. 7, the operations of the controller 320 may include operation S201 of calculating the cumulative voltage variance $V_{\Delta tot}$ of each of the plurality of battery units 110, 120, ..., 130, operation S203 of calculating the second deviation D2 that is a deviation of the cumulative voltage variances $V_{\Delta tot}$ for each of the plurality of vehicles 10 and 20, operation S205 of calculating the second distribution P2 of the plurality of vehicles 10 and 20 based on the second deviation D2, operation S207 of diagnosing the abnormal vehicle 10 based on the second distribution P2, and operation S209 of diagnosing, as being in the insulation abnormality state, the battery unit 130 having the minimum cumulative voltage variance among the plurality of battery units 110, 120, ..., 130 included in the abnormal vehicle 10.

In operation S201, the controller 320 may calculate the cumulative voltage variance $V_{\Delta tot}$ of each of the plurality of battery units 110, 120, ..., 130. According to an embodiment, the controller 320 may calculate the cumulative voltage variance $V_{\Delta tot}$ of each of the plurality of battery units 110, 120, ..., 130, based on the voltage information of each of the plurality of battery units 110, 120, ..., 130 included in each of the plurality of vehicles 10 and 20.

In operations S202 and S203, the controller 320 may calculate the first deviation D1 or the second deviation D2 that is a deviation of the cumulative voltage variances $V_{\Delta tot}$ for each of the plurality of vehicles 10 and 20.

In operations S204 and S205, the controller 320 may calculate the first distribution P1 of the plurality of vehicles 10 and 20 based on the first deviation D1 in operation S204. Also, the controller 320 may calculate the second distribution P2 of the plurality of vehicles 10 and 20 based on the second deviation D2, in operation S205.

In operations S206 and S207, the controller 320 may diagnose the abnormal vehicle 10 based on the first distribution P1 or the second distribution P2 of the plurality of vehicles 10 and 20.

In operations S208 and S209, the controller 320 may diagnose the battery unit 110 having the maximum cumulative voltage variance among the plurality of battery units 110, 120, ..., 130 included in the abnormal vehicle 10, as being in the capacity abnormality state, and diagnose the battery unit 130 having the minimum cumulative voltage variance as being in the insulation abnormality state.

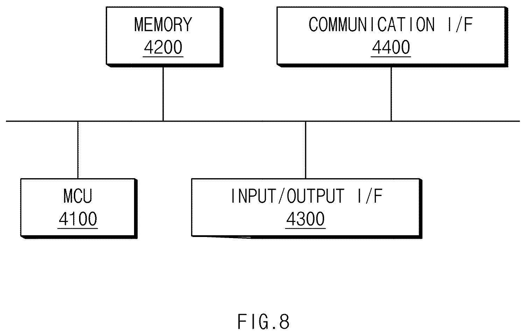

FIG. 8 is a block diagram showing a hardware configuration of a computing system for implementing an operating method of a battery management apparatus, according to an embodiment disclosed herein.

Referring to FIG. 8, a computing system 4000 of a battery diagnosis apparatus 3000 according to an embodiment disclosed herein may include an MCU 4100, a memory 4200, an input/output I/F 4300, and a communication I/F 4400. However, this is merely an example, and various embodiments are not limited thereto. For example, at least one of the above-described components of the battery diagnosis apparatus 3000 may be omitted, or one or more other components (e.g., an input device, at least one sensor, a power management device, etc.) may be added as components of the battery diagnosis apparatus 3000. At least one of the above-described components may be integrated with other components.

The MCU 4100 may be a processor that executes various programs (e.g., a battery voltage analysis program, etc.) stored in the memory 4200, processes various data through these programs, and perform the above-described functions of the battery diagnosis apparatus 3000 shown in FIG. 1.

According to an embodiment, the MCU 4100 may control at least one other component (e.g., the memory 4200, the input/output I/F 4300, and the communication I/F 4400) of the battery diagnosis apparatus 3000 and perform various information processing or operations.

According to an embodiment, the MCU 4100 may execute software stored in the memory 4200 to control at least one other component (e.g., a hardware or software component) of the battery diagnosis apparatus 3000 connected to the MCU 4100 or to perform an operation of the battery diagnosis apparatus 3000.

The memory 4200 may store various programs regarding operations of the battery diagnosis apparatus 3000. Moreover, the memory 4200 may store operation data of the battery diagnosis apparatus 3000.

According to an embodiment, the memory 4200 may obtain information obtained from the communication I/F 4400. For example, the memory 4200 may store voltage information obtained in charging/discharging sections of the plurality of battery units 110, 120, ..., 130. According to an embodiment, the memory 4200 may store one or more programs used in a mathematical or logical operation process of the battery diagnosis apparatus 3000. For example, the memory 4200 may include a program related to an interquartile range (IQR) analysis method or a statistical data analysis method.

The memory 4200 may be provided in plural, depending on a need. The memory 4200 may be a volatile or nonvolatile memory. For the memory 4200 as the volatile memory, random access memory (RAM), dynamic RAM (DRAM), static RAM (SRAM), etc., may be used. For the memory 4200 as the non-volatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 4200 are merely examples and are not limited thereto.

The input/output I/F 4300 may provide an interface for transmitting and receiving data by connecting an input device (not shown) such as a keyboard, a mouse, a touch panel, etc., and an output device such as a display (not shown), etc., with the MCU 4100.

The communication I/F 4400 may establish a wired communication channel and/or a wireless communication channel between the battery diagnosis apparatus 3000 and another device, and transmit and receive information through the established communication channel. According to an embodiment, the communication I/F 4400 may receive information from a communication module (not shown) included in the battery management apparatus 200. For example, the communication I/F 4400 of the battery diagnosis apparatus 3000 may receive information related to the battery unit 110. Herein, the information related to the battery unit 110 may include at least one of unique identification number information, type information, use cycle information, voltage information, current information, temperature information, resistance information, a depth of charging information, SOC information, and C-rate information of the battery unit 110.

According to an embodiment, connection between the communication I/F 4400 of the battery diagnosis apparatus 3000 and a communication module (not shown) the battery management apparatus 200 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

According to an embodiment, the connection between the communication I/F 4400 of the battery diagnosis apparatus 3000 and the communication module (not shown) of the battery management apparatus 200 may be connection using a device-to-device communication scheme (e.g., a bus, a general-purpose input and output (GPIO), a serial peripheral interface (SPI), or a mobile industry processor interface (MIPI)).

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The foregoing disclosure may roughly show features of several embodiments to allow those of ordinary skill in the art to better understand aspects of the present disclosure. Those of ordinary skill in the art will appreciate that they may readily use the present disclosure as a basis for designing or modifying other structures to carry out the same purposes or achieve the same advantages of the embodiments introduced herein. Additionally, it would be recognized by those of ordinary skill in the art that such equivalent configurations may not depart from the scope of the present disclosure, and various changes, substitutions, and modifications may be made herein without departing from the scope of the present disclosure.

**Claims**

1. A battery diagnosis apparatus comprising:

   a voltage obtaining unit configured to obtain voltage information of each of a plurality of battery units included in each of a plurality of vehicles; and
   a controller configured to:

   calculate a cumulative voltage variance of each of the plurality of battery units, based on the voltage information;
calculate at least one deviation that is deviation of cumulative voltage variances for each of the plurality of vehicles; and manage the plurality of battery units based on a distribution of the at least one deviation of the plurality of vehicles.

2. The battery diagnosis apparatus of claim 1, wherein the at least one deviation of each of the plurality of vehicles comprises at least one of a first deviation and a second deviation.

3. The battery diagnosis apparatus of claim 2, wherein the controller is further configured to calculate the first deviation by dividing a difference between a maximum value and a median value of the cumulative voltage variance of each of the plurality of battery units included in each of the plurality of vehicles by a standard deviation of the cumulative voltage variance of each of the plurality of battery units.

4. The battery diagnosis apparatus of claim 2, wherein the controller is further configured to calculate the second deviation by dividing a difference between a minimum value and a median value of the cumulative voltage variance of each of the plurality of battery units included in each of the plurality of vehicles by a standard deviation of the cumulative voltage variance of each of the plurality of battery units.

5. The battery diagnosis apparatus of claim 2, wherein the controller is further configured to:

   calculate a first distribution of the plurality of vehicles based on the first deviation; and calculate a second distribution of the plurality of vehicles based on the second deviation.

6. The battery diagnosis apparatus of claim 1, wherein the controller is further configured to diagnose, as an abnormal vehicle comprising an abnormal battery unit, a vehicle having the deviation being greater than or equal to a threshold value in the distribution of the at least one deviation of the plurality of vehicles.

7. The battery diagnosis apparatus of claim 6, wherein the controller is further configured to diagnose, as being in a capacity abnormality state, a battery unit having a maximum cumulative voltage variance among a plurality of battery units included in the abnormal vehicle.

8. The battery diagnosis apparatus of claim 6, wherein the controller is further configured to diagnose, as being in an insulation abnormality state, a battery unit having a minimum cumulative voltage variance among a plurality of battery units included in the abnormal vehicle.

9. The battery diagnosis apparatus of claim 1, wherein the voltage information comprises a voltage obtained in a charging section of the plurality of battery units.

10. A battery diagnosis method comprising:

    obtaining voltage information of each of a plurality of battery units included in each of a plurality of vehicles;
    calculating a cumulative voltage variance of each of the plurality of battery units, based on the voltage information;
    calculating at least one deviation that is deviation of cumulative voltage variances for each of the plurality of vehicles; and managing the plurality of battery units based on a distribution of the at least one deviation of the plurality of vehicles.

11. The battery diagnosis method of claim 10, wherein the at least one deviation of each of the plurality of vehicles comprises at least one of a first deviation and a second deviation.

12. The battery diagnosis method of claim 11, wherein the calculating of the at least one deviation comprises calculating the first deviation by dividing a difference between a maximum value and a median value of the cumulative voltage variance of each of the plurality of battery units included in each of the plurality of vehicles by a standard deviation of the cumulative voltage variance of each of the plurality of battery units.

13. The battery diagnosis method of claim 11, wherein the calculating of the at least one deviation comprises calculating the second deviation by dividing a difference between a minimum value and a median value of the cumulative voltage variance of each of the plurality of battery units included in each of the plurality of vehicles by a standard deviation of the cumulative voltage variance of each of the plurality of battery units.

14. The battery diagnosis method of claim 11, further comprising:

    calculating a first distribution of the plurality of vehicles based on the first deviation; and calculating a second distribution of the plurality of vehicles based on the second deviation.

15. The battery diagnosis method of claim 10, wherein the managing of the plurality of battery units comprises diagnosing, as an abnormal vehicle comprising an abnormal battery unit, a vehicle having the deviation being greater than or equal to a threshold value in the distribution of the at least one deviation of the plurality of vehicles.

16. The battery diagnosis method of claim 15, further comprising diagnosing, as being in a capacity abnormality state, a battery unit having a maximum cumulative voltage variance among a plurality of battery units included in the abnormal vehicle.

17. The battery diagnosis method of claim 15, further comprising diagnosing, as being in an insulation abnormality state, a battery unit having a minimum cumulative voltage variance among a plurality of battery units included in the abnormal vehicle.

18. The battery diagnosis method of claim 10, wherein the voltage information comprises a voltage obtained in a charging section of the plurality of battery units.

1

10                                          20

BATTERY PACK
1000                    • • •         BATTERY PACK
2000

BATTERY DIAGNOSIS APAPRATUS
3000

FIG.1

BATTERY PACK
1000

HIGHER-LEVEL BATTERY UNIT
100

| BATTERY UNIT 110 | BATTERY UNIT 120 | • • • | BATTERY UNIT 130 |

BATTERY MANAGEMENT APPARATUS
200

FIG.2

3000

| VOLTAGE OBTAINING UNIT 310 | | CONTROLLER 320 |

FIG.3

FIG.4

FIG.5

OBTAIN VOLTAGE INFORMATION OF EACH OF PLURALITY OF BATTERY UNITS — S101

CALCULATE CUMULATIVE VOLTAGE VARIANCE OF EACH OF PLURALITY OF BATTERY UNITS — S102

CALCULATE AT LEAST ON DEVIATION THAT IS DEVIATION OF CUMULATIVE VOLTAGE VARIANCES FOR EACH OF PLURALITY OF VEHICLES — S103

MANAGE PLURALITY OF BATTERY UNITS BASED ON DISTRIBUTION OF AT LEAST ONE DEVIATION OF PLURALITY OF VEHICLES — S104

FIG.6

CALCULATE CUMULATIVE VOLTAGE VARIANCE OF EACH OF PLURALITY OF BATTERY UNITS ~S201

CALCULATE FIRST DEVIATION OF CUMULATIVE VOLTAGE VARIANCES FOR EACH OF PLURALITY OF VEHICLES ~S202

CALCULATE SECOND DEVIATION OF CUMULATIVE VOLTAGE VARIANCES FOR EACH OF PLURALITY OF VEHICLES ~S203

CALCULATE FIRST DISTRIBUTION OF PLURALITY OF VEHICLES BASED ON FIRST DEVIATION ~S204

CALCULATE SECOND DISTRIBUTION OF PLURALITY OF VEHICLES BASED ON SECOND DEVIATION ~S205

DIAGNOSE ABNORMAL VEHICLE BASED ON FIRST DISTRIBUTION ~S206

DIAGNOSE ABNORMAL VEHICLE BASED ON SECOND DISTRIBUTION ~S207

DIANOSE, AS BEING IN CAPACITY ABNORMALITY STATE BATTERY UNIT HAVING MAXIMUM CUMULATIVE VOLTAGE VARIANCE AMONG PLURALITY OF BATTERY UNITS INCLUDED IN ABNORMAL VEHICLE ~S208

DIANOSE, AS BEING IN INSULATION ABNORMALITY STATE, BATTERY UNIT HAVING MINIMUM CUMULATIVE VOLTAGE VARIANCE AMONG PLURALITY OF BATTERY UNITS INCLUDED IN ABNORMAL VEHICLE ~S209

FIG.7

22

MEMORY
4200

COMMUNICATION I/F
4400

MCU
4100

INPUT/OUTPUT I/F
4300

FIG.8

## INTERNATIONAL SEARCH REPORT

| International application No. |
|---|
| **PCT/KR2024/012333** |

### A. CLASSIFICATION OF SUBJECT MATTER

**G01R 31/392**(2019.01)i; **G01R 31/385**(2019.01)i; **G01R 31/382**(2019.01)i; **G01R 19/12**(2006.01)i; **G01R 19/10**(2006.01)i; **G01R 19/30**(2006.01)i; **G01R 19/165**(2006.01)i; **B60L 58/16**(2019.01)i; **B60R 16/033**(2006.01)i; **H01M 10/052**(2010.01)i

According to International Patent Classification (IPC) or to both national classification and IPC

### B. FIELDS SEARCHED

Minimum documentation searched (classification system followed by classification symbols)

G01R 31/392(2019.01); B60R 16/033(2006.01); G01R 31/36(2006.01); G01R 31/367(2019.01); G01R 31/396(2019.01); G01R 31/50(2020.01); H01M 10/48(2006.01); H02J 3/32(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 차량(vehicle), 배터리(battery), 전압(voltage), 편차값(deviation value), 진단 (diagnosis)

### C. DOCUMENTS CONSIDERED TO BE RELEVANT

| Category* | Citation of document, with indication, where appropriate, of the relevant passages | Relevant to claim No. |
|---|---|---|
| Y | KR 10-2021-0059566 A (SAMSUNG SDI CO., LTD.) 25 May 2021 (2021-05-25)<br>See paragraphs [0035]-[0040] and claim 1. | 1-18 |
| Y | WO 2020-044713 A1 (HONDA MOTOR CO., LTD.) 05 March 2020 (2020-03-05)<br>See claims 1 and 4. | 1-18 |
| A | KR 10-2021-0141212 A (LG ENERGY SOLUTION, LTD.) 23 November 2021 (2021-11-23)<br>See claims 1 and 7-14 and figure 7. | 1-18 |
| A | KR 10-2021-0095051 A (LG ENERGY SOLUTION, LTD.) 30 July 2021 (2021-07-30)<br>See paragraphs [0106]-[0117] and figures 6-7. | 1-18 |
| A | JP 2021-158905 A (HONDA MOTOR CO., LTD.) 07 October 2021 (2021-10-07)<br>See claims 1-9 and figures 4-5. | 1-18 |

☐ Further documents are listed in the continuation of Box C.   ☑ See patent family annex.

| | |
|---|---|
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **21 November 2024** | **21 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

EP 4 707 834 A1

INTERNATIONAL SEARCH REPORT
Information on patent family members

International application No.

**PCT/KR2024/012333**

| Patent document cited in search report | | | Publication date (day/month/year) | Patent family member(s) | | | Publication date (day/month/year) |
|---|---|---|---|---|---|---|---|
| KR | 10-2021-0059566 | A | 25 May 2021 | KR | 10-2362208 | B1 | 10 February 2022 |
| WO | 2020-044713 | A1 | 05 March 2020 | CN | 112534625 | A | 19 March 2021 |
| | | | | CN | 112534625 | B | 13 August 2024 |
| | | | | JP | 7062775 | B2 | 06 May 2022 |
| | | | | US | 2021-0291698 | A1 | 23 September 2021 |
| | | | | WO | 2020-044713 | A1 | 05 March 2020 |
| KR | 10-2021-0141212 | A | 23 November 2021 | AU | 2021-270154 | A1 | 26 May 2022 |
| | | | | CN | 114585939 | A | 03 June 2022 |
| | | | | EP | 4040174 | A1 | 10 August 2022 |
| | | | | JP | 2022-551451 | A | 09 December 2022 |
| | | | | JP | 7313762 | B2 | 25 July 2023 |
| | | | | US | 11959969 | B2 | 16 April 2024 |
| | | | | US | 2022-0390521 | A1 | 08 December 2022 |
| | | | | WO | 2021-230642 | A1 | 18 November 2021 |
| KR | 10-2021-0095051 | A | 30 July 2021 | CN | 114127570 | A | 01 March 2022 |
| | | | | CN | 114127570 | B | 20 October 2023 |
| | | | | EP | 4016101 | A1 | 22 June 2022 |
| | | | | EP | 4016101 | B1 | 20 March 2024 |
| | | | | JP | 2022-540403 | A | 15 September 2022 |
| | | | | JP | 7364160 | B2 | 18 October 2023 |
| | | | | US | 2022-0268853 | A1 | 25 August 2022 |
| | | | | WO | 2021-149973 | A1 | 29 July 2021 |
| JP | 2021-158905 | A | 07 October 2021 | CN | 113459899 | A | 01 October 2021 |
| | | | | CN | 113459899 | B | 28 May 2024 |
| | | | | JP | 7134193 | B2 | 09 September 2022 |
| | | | | US | 11571971 | B2 | 07 February 2023 |
| | | | | US | 2021-0300184 | A1 | 30 September 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230125303